# EUROPÄISCHE PATENTSCHRIFT

(11) **EP 1 835 048 B1**
(45) Veröffentlichungstag und Bekanntmachung des Hinweises auf die Patenterteilung: **06.05.2009**
(21) Anmeldenummer: 07004978.8
(22) Anmeldetag: 10.03.2007
(51) Int. Cl.: C23C 14/50

(54) **Vakuumbeschichtungsanlage und Kalotte mit einer Vorrichtung zum Halten sowie zum Drehen und/oder Wenden eines Gegenstands, und Verfahren.**
Vacuum coating facility and calotte comprising a device for holding and turning and/or rotating an object, and method thereof.
Installation de revêtement sous vide et calotte comprenant un dispositif destiné à maintenir et tourner et/ou retourner un objet, et procédé correspondant.

(30) Priorität: 17.03.2006 DE 102006012747
(43) Veröffentlichungstag der Anmeldung: 19.09.2007
(73) Patentinhaber: Carl Zeiss Vision GmbH, 73430 Aalen (DE)
(72) Erfinder: Littek, Martin, 73579 Schechingen (DE); Kurz, Norbert, 73433 Aalen (DE)
(74) Vertreter: Braunger, Dieter

(56) Entgegenhaltungen:
- EP-A2- 0 406 483
- GB-A- 1 392 292
- US-A1- 2003 206 794
- US-B1- 6 828 772

## Beschreibung

Die Erfindung betrifft eine Vakuumbeschichtungsanlage nach dem Oberbegriff des Patentanspruchs 1. Die Erfindung betrifft ferner ein Verfahren nach dem Patentanspruch 24.

Unter Vakuumbeschichtungsanlage ist vorliegend eine Anlage zu verstehen, mit der unter Vakuum-, insbesondere Hochvakuumbedingungen Gegenstände beschichtet werden können. Hierzu gehören beispielsweise Kathodenzerstäubungsanlagen, Bedampfungsanlagen, mit denen z.B. mittels Elektronenstrahl oder thermisch bestimmte Materialien verdampft werden können, oder chemische Gasphasenabscheidungsanlagen. Unter einem optischen Element wird nachfolgend ein Gegenstand verstanden, welcher bestimmungsgemäß eine elektromagnetische Strahlung, wie z.B. sichtbares Licht, UV- oder IR-_Strahlung absorbierende, transmittierende, reflektierende, brechende oder streuende Funktion aufweist. Insbesondere gehören hierzu Linsen, beispielsweise Brillenlinsen oder Kontaktlinsen. Weiter gehören hierzu Plan- und Rundoptiken, Prismen, sphärische oder asphärische Gläser, formgerandete Brillengläser, elliptische Gläser usw. Unter nichtoptischem Element wird nachfolgend ein Gebrauchsgegenstand verstanden. Beispielhaft seien Werkzeuge oder Teile hiervon, wie z.B. Bohrer, oder Anlagenteile genannt. Unter Drehen versteht man nachfolgend eine Rotationsbewegung des optischen Elements, bei der die der Beschichtungsquelle zugewandte Seite weiterhin der Beschichtungsquelle zugewandt bleibt. Unter Wenden versteht man nachfolgend einen Vorgang, bei der sich die der Beschichtungsquelle zugewandte Fläche ändert. Nach einem Wenden um 180° ist die Rückseite des optischen Elements der Beschichtungsquelle zugewandt.

Vorrichtungen zum Halten sowie zum Drehen und/oder Wenden von optischen Elementen, insbesondere von Linsen, bei deren Beschichtung in einer Vakuumbeschichtungsanlage sind aus dem Stand der Technik in einer Vielzahl von Abwandlungen bekannt.

So ist es beispielsweise bekannt und z.B. in der EP 0 959 147 A2 beschrieben, die zu beschichtenden optischen Elemente in entsprechende Öffnungen einer im allgemeinen gewölbten Kalotte (z.B. in Form eines Schirms oder Kugelsegments) einzusetzen. Die optischen Elemente liegen dabei in der Regel am Rand auf. Es gibt Ausführungen, bei denen die optischen Elemente von der Rückseite her gegen die Auflagefläche gedrückt werden. Auch gibt es Varianten, bei denen die optischen Elemente in eigene Halter eingesetzt sind.

Der EP 0 215 261 A2 entnimmt man eine Linsenhalterung für zu reinigende und nachfolgend zu beschichtende Brillenglaslinsen, welche z.B. in eine Kalotte der vorstehend beschriebenen Art eingesetzt werden kann. Die Halterung besitzt die Form eines Ringes, der an seiner Innenseite Gabeln zur Aufnahme der zu haltenden Linsen aufweist. Der Ring ist elastisch verformbar und die Gabeln sind an zwei einander gegenüber liegenden Abschnitten der Ringinnenseite angeordnet. Dies ermöglicht nach Ansicht der Anmelderin dieser Patentanmeldung ein arbeitssparendes Einspannen -sogar mit bloß einer Hand- der Linsen und erlaubt eine große Durchmessertoleranz und die Verwendung ein und derselben Haltevorrichtung für mehrere Arbeitsgänge.

Um Vorder- und Rückseite der jeweiligen optischen Elemente beschichten zu können, müssen die optischen Elemente ggf. zusammen mit ihren Haltern manuell entnommen und gewendet werden. Dies erfordert eine Unterbrechung des Beschichtungsvorgangs, eine Belüftung der Anlage und eine Entnahme der die optischen Elemente tragenden Kalotte. Diese Prozedur erfordert vergleichsweise viel Zeit, Energie und Manpower.

Weiterhin sind aus dem betriebsintern bekannten Stand der Technik teilautomatisierte Kleinanlagen bekannt, bei denen z.B. vier Linsen in entsprechenden einzelnen Halterungen gleichzeitig gewendet werden können.

Die DE 35 13 137 A1 beschreibt eine Mehrfach-Haltevorrichtung für zu behandelnde, z.B. zu reinigende und nachfolgend durch Vakuumdampfen oder Kathodenzerstäubung zu beschichtende Substrate, vorzugsweise für fertig zugeschliffene Brillengläser. Die Mehrfach-Haltevorrichtung weist Halteschienen mit Nuten zur Halterung der Substrate an ihrem Rand auf. Es sind Anpressfedern vorhanden, um die Substrate in die Nuten zu drücken. Die Halteschienen bilden ein Kreuz, dessen vier Balken auf ihren den vier Quadranten zugewandten Seiten mit einer Nut versehen sind. Die Aufnahme von Brillenglaslinsen verschiedener Größen und das Auswechseln der Gläser bzw. das Wenden, um ggf. beide Seiten zu beschichten, ist angeblich sehr einfach.

Eine Übertragung der Mechanik der vorstehend beschriebenen beiden Varianten auf größere Beschichtungsanlagen, welche 100 oder mehr optische Elemente gleichzeitig aufnehmen und beschichten können, ist nicht möglich.

Aus der FR 2 602 244 A1 ist ein Halter zum Halten einer einzigen Linse an deren Außenumfang bekannt. Zu diesem Zweck ist eine Einrichtung vorhanden, welche die kreisrunde Linse an deren Außenumfang flächig oder punktuell unter Federkraftbeaufschlagung umklammert. Eine Vielzahl dieser Halter sind an entsprechenden Linsenöffnungen einer gewölbten Kalotte angebracht. Die Kalotte umfasst mehrere Kalottensegmente, wobei jedes dieser Kalottensegmente wiederum eine Mehrzahl an Haltern trägt. Jedes Kalottensegment ist um eine Mittenachse drehbar, so dass eine Mehrzahl von in den Haltern gehalterten Linsen gleichzeitig um 180° gewendet werden können.

Auch die DE 41 15 175 A1 und die CH 691 308 A5 offenbaren Halter zum Halten einer einzigen Linse. Es sind zwei halbkreisförmige Bügel vorgesehen, welche die Linse außenumfangsseitig umgreifen. Die Bügel weisen den Linsenoberflächen zugeordnete Auflageflächen auf. Auch hier sind eine Vielzahl dieser Halter an entsprechenden Linsenöffnungen einer gewölbten Kalotte angebracht. Die Kalotte umfasst wiederum mehrere Kalottensegmente mit einer Mehrzahl an Haltern. Jedes Kalottensegment kann gewendet werden.

Die in den drei vorstehend angegebenen Dokumenten beschriebenen Ausführungsvarianten erlauben zwar ein vollautomatisches Wenden ohne Bruch des Vakuums, die Linsen sind jedoch nach Überschreiten des Totpunktes hohen Kraftimpulsen mit der Gefahr des Substratverlusts ausgesetzt.

Die EP 0 406 484 B1 und die EP 0 406 483 A2, von denen die Erfindung ausgeht, offenbaren Vorrichtungen zum Halten und Wenden von Linsen für in einer Hochvakuum-Aufdampfanlage oder -Sputteranlage zu beschichtende Brillenglaslinsen. Die Vorrichtung umfasst ein die zu haltende Linse tragendes Ringpaar, das seinerseits mit einem Substrathalter verbindbar ist, der in der Prozesskammer der Hochvakuumanlage gehalten ist. Das schirmartig bzw. halbschalenartig ausgeformte Blechteil, das den Substrathalter bildet, ist zumindest teilweise von einem sichelförmigen, einen Schieber oder Rechen bildenden Blechzuschnitt oder Profilelement übergriffen. Die dem Substrathalter zugewandte Kante des Rechens ist in einem geringen Abstand zur Außenfläche des Substrathalters von einem in der Prozesskammer angeordneten Gleitstück oder Gelenkarm gehalten. Der Rechen ist in dieser Lage gegenüber der Oberseite des Substrathalters um die Rotationsachse des Substrathalters bewegbar. Die dem Substratträger zugewandte Unterkante der einzelnen Zinken des Rechens gelangen dabei in Eingriff mit den Ritzeln oder Zahnrädern der auf Zapfen gelagerten Ringpaare und schwenken diese um 180°, wenn sich dabei der Substrathalter seinerseits gleichzeitig um die Rotationsachse dreht.

Die EP 0 547 312 A1 beschreibt eine Substrathalte- und Wendevorrichtung für Vakuumprozesse. Die Haltevorrichtung umfasst eine Federspange zum einspannenden Halten der Substrate bzw. Linsen. Die Federspange wird von einem Tragring gehalten. Der Tragring weist radial nach außen verlaufende Befestigungselemente auf, welche sich am Rand einer den Tragring aufnehmenden Öffnung abstützen können. Die Befestigungselemente können als Lager für eine Wendevorrichtung ausgebildet sein. Die Wendevorrichtung kann beispielsweise einen Wendehebel umfassen, um den Tragring um 180° zu wenden. Damit ist es möglich, eine Linse in einer Bearbeitungsanlage nacheinander beidseitig zu bearbeiten bzw. zu beschichten. Eine Mehrzahl solcher Haltevorrichtungen können auf einer Kalotte in der vorstehend beschriebenen Form angeordnet sein. Ein Einschwenkmechanismus zum Wenden der einzelnen Substrathalter kann mittels eines Ansenkmechanismus gegen das kalottenartige Halteorgan abgesenkt werden. Wenn der Einschwenkmechanismus ausreichend abgesenkt ist, greifen die einzelnen Wendehaken an den Wendehebeln der einzelnen Substrathalterungen ein, und durch Drehen des Halteorgans um 360° werden sämtliche Substrathalter um 180° gewendet.

Die EP 0 497 651 B1 beschreibt einen einzelnen wendbaren Halter. Auch hier können eine Mehrzahl einzelner Halter auf einer Kalotte angeordnet werden.
Es ist ein Wendemechanismus vorhanden, der funktional den in der EP 0 406 484 B1, der EP 0 406 483 A2 oder der EP 0 547 312 A1 beschriebenen Varianten ähnelt.

Obwohl sich auch die Ausführungsvarianten mit individuellem Halter und zugeordnetem Wendemechanismus dem Grunde nach bewährt haben, ist die Mechanik zum vollautomatischen Wenden vergleichsweise störanfällig. Zum Annähern an den Kalottenradius ist eine wartungsaufwändige Mechanik erforderlich, welche zudem die Belegungskapazität deutlich verringert. Beim mechanischen Reinigungsprozess Sandstrahlen muss mit erheblichem Verschleiß gerechnet werden. Die der Anmelderin bekannten Ausführungen sind ferner ausschließlich zum Wenden kreisrunder Linsengeometrien geeignet. Auch hier sind die Linsen nach Überschreiten des Totpunktes hohen Kraftimpulsen ausgesetzt mit der Gefahr des Substratverlusts.

Die Aufgabe der Erfindung besteht nunmehr darin, eine Vakuumbeschichtungsanlage mit einer Vorrichtung zum Halten sowie zum Drehen und/oder Wenden von Gegenständen, insbesondere optischer Elemente wie z.B. Linsen oder nichtoptischer Elemente wie z.B. eines Bohrers, bei deren Beschichtung, ein entsprechendes Verfahren und eine Kalotte mit einer erfindungsgemäßen Halte- und Wendevorrichtung bereitzustellen, bei denen die oben genannten Probleme nicht mehr auftreten.

Diese Aufgabe wird durch die Merkmale des Patentanspruchs 1, und ein entsprechendes Verfahren mit den Merkmalen des Patentanspruchs 24 gelöst.

Vorteilhafte Ausführungen und Weiterbildungen der Erfindung sind in den Unteransprüchen angegeben.

Erfindungsgemäß ist dem individuellen Halter ein individueller automatischer Antrieb oder sogar mehrere automatische Antriebe zum Drehen und/oder Wenden zugeordnet. Die Vorgänge des Zwischenflutens werden durch die Erfindung beseitigt. Dadurch reduziert sich sich der Handlingsaufwand. Eine vergleichsweise aufwendige Mechanik zum gleichzeitigen Drehen und/oder Wenden einer Vielzahl an Gegenständen, wie z.B. optischen Elementen, entfällt. Der Wende- oder Drehvorgang selbst ist unter Vakuum mindestens einmalig, idealerweise jedoch reversibel durchführbar. Der individuelle Linsenhalter ermöglicht das Halten unterschiedlichster (Linsen-)Geometrien während des Beschichtungsvorgangs.

Der individuelle Halter kann (vorzugsweise lösbar) mit dem zu beschichtenden Gegenstand verbunden sein. Gegenstand und Halter können sich vorzugsweise ohne äußere mechanische Einwirkung beim Drehen und/oder Wenden nicht voneinander trennen. Eine Verbindung durch ankleben (vorzugsweise an lediglich zwei voneinander beabstandeten Stellen) oder Anklemmen ist günstig. Eine bloße Auflage ist also nicht als Verbund anzusehen. Der individuelle Halter kann ggf. zusammen mit dem individuellen Antrieb zum Drehen und/oder Wenden so lange mit dem Gegenstand (z.B. optischen Element) in einem Verbund verbleiben, bis mehrere, eine Vielzahl oder gar sämtliche Bearbeitungsschritte (nicht nur die Beschichtung) abgeschlossen sind.

Der Einsatz von Einwegkomponenten kann die Performance (Logistik, Prozesssicherheit, geringerer Instandhaltungsaufwand) steigern. Eine Ausführung als schnell wechselbare Funktionseinheit unterstützt diesen Ansatz. So sind die Bestückung einer Kalotte mit einer Mehrzahl individueller Halter mit Dreh- und/oder Wendeantrieb und deren anschließende Entnahme aus der Kalotte vergleichsweise einfach. Im Falle eines elektrischen Antriebs können die Mittel zur Befestigung der Halte- und Dreh-/Wende-Vorrichtung gleichzeitig als Mittel zur elektrischen Kontaktierung verwendet werden. Von Vorteil sind ein geringes Gewicht der gesamten Funktionseinheit, eine geometrisch kompakte Ausführung und niedrige Herstellkosten (Einsatz in Serienfertigung, Wartung).

Durch die Erfindung sind bisher durch den Zeitaufwand unrentable Beschichtungsabläufe/ -kombinationen denkbar. Als Beispiel soll das mögliche wechselseitige Aufbringen von Front- und Backside-Schichten in Folge genannt werden, um z.B. den Einfluss störender Hinterbedampfungen zu minimieren.

Es hat sich als günstig herausgestellt, den mindestens einen individuellen Antrieb als Direktantrieb auszuführen. Die Anzahl beweglicher Komponenten ist bei dieser Art von Antrieb gering, wodurch die Ausfallwahrscheinlichkeit ebenfalls klein ist. Insbesondere für optische Elemente mit kleinem Gewicht und für Drehbewegungen eignet sich ein derartiger Direktantrieb.

Für vergleichsweise schwere Gegenstände (schwere optische Elemente, Anlagenteile, Bohrer oder dergleichen), Halter mit hohem Eigengewicht und/oder Wendevorgänge kann ein Direktantrieb aufgrund dessen begrenzter Leistung nicht ausreichend sein. Insbesondere für derartige Fälle sieht die Erfindung vor, dass der individuelle Antrieb ein untersetzendes Getriebe umfasst. In anderen Fällen, in denen keine hohen Kräfte oder Momente erforderlich sind, z.B. beim Drehen eines optischen Elements oder wenn der Verbund aus optischem Element und Halter nur ein geringes Eigengewicht aufweist, kann auch -falls erforderlich- ein übersetzendes Getriebe eingesetzt werden.

Die erforderliche Kraft kann auch durch den Einsatz mehrerer automatischer Antriebe, wie z.B. durch die Verwendung mehrerer Motoren oder Aktuatoren erzielt werden. Diese können sowohl ortsfest angeordnet (z.B. fixiert) sein, als auch während des Wendeund/oder Drehvorgangs mitbewegt werden.

Es können Stirnradgetriebe und/oder Schneckengetriebe und/oder Planetengetriebe und/oder Kugelgetriebe und/oder Harmonic Drive Getriebe zum Einsatz kommen. Stirnradgetriebe und Schneckengetriebe sind vergleichsweise kostengünstig. Ein Schneckengetriebe kann aufgrund dessen selbsthemmender Eigenschaft vorteilhaft sein, wenn der Gegenstand (z.B. das optische Element) in bestimmter Weise in Bezug auf die Beschichtungsquelle positioniert werden muss. Ein unerwünschtes Verdrehen ist dann nicht mehr möglich. Das Harmonic Drive Getriebe, welches Walter Musser 1959 in den USA als Umlaufgetriebe für die Luft- und Raumfahrt entwickelte, umfasst als Antriebselement eine elliptische Scheibe. Diese verformt über ein Kugellager eine flexible Stahlbüchse mit Abtriebsflansch. Die Außenverzahnung der Büchse greift an den Längsenden der Ellipse in die Innenverzahnung des Gehäuserings. Er besitzt zwei Zähne mehr wie die Büchse. Dreht sich die Antriebsscheibe, wandern die Eingriffszonen weiter. Bei einer Umdrehung schiebt sich die Büchse um zwei Zähne in die entgegengesetzte Richtung. Harmonic Drive Getriebe arbeiten auf kleinstem Raum mit hoher Untersetzung und großer Präzision. Eine weitgehend erschütterungsfreie und genaue Positionierung des Gegenstands (wie z.B. des optischen Elements) ist mit einem derartigen Getriebe möglich.

Um das Auftreten unerwünschter und ggf. den Verbund aus Halter und Gegenstand (wie optischem Element) zerstörenden Kräfte zu verhindern, ist eine die Antriebskraft und/oder das Antriebsmoment des individuellen Antriebs auf den individuellen Halter übertragende Reibeinrichtung vorgesehen. Eine Überbeanspruchung kann dann vom Schlupf der Reibeinrichtung aufgenommen werden. Liegen die auftretenden Kräfte oder Momente unter einem vorzugsweise definiert vorgegebenen Wert, überträgt der Antrieb seine Kraft bzw. sein Moment mittelbar oder unmittelbar auf den Verbund aus Halter und Gegenstand (d.h. z.B. optischem Element).

Halter und Antrieb lassen sich besonders schnell und einfach miteinander koppeln, wenn der individuelle Halter und der individuelle Antrieb mittelbar oder unmittelbar formschlüssig miteinander verbindbar sind. Der Antrieb kann z.B. eine Außenkontur aufweisen, welche mit einer Innenkontur des Halters korrespondiert, oder umgekehrt. Es ist auch möglich, den individuellen Halter und den individuellen Antrieb bzw. die individuellen Antriebe gleichsinnig lageorientiert (so dass keine Verwechslung der Beschichtungsseite möglich ist, z.B. stets Vorder- oder Rückseite) und z.B. mittels einer Nase oder dergleichen miteinander zu verbinden.

Es kann eine Positioniereinrichtung vorgesehen sein, um den individuellen Halter beim Drehen und/oder Wenden in eine vorbestimmte Position zu verbringen. Dies ist insbesondere dann von Vorteil, wenn die Beschichtung über einen gerichteten Strahl erfolgt. Insbesondere bei der Verdampfung von Materialien mittels Elektronenkanone oder thermisch erhitztem Verdampfungstiegel ist es wichtig, den Gegenstand und insbesondere das optische Element, wie z.B. die Brillenlinse oder die Kontaktlinse, mit seiner zu beschichtenden Seite auf den Verdampfungskegel auszurichten.

Obwohl es grundsätzlich möglich ist, die genaue Lage des Halters oder des zu beschichtenden Gegenstands, vorzugsweise des optischen Elements, z.B. mit Hilfe von Lichtschranken, Magneten oder sonstigen Detektoren zu detektieren, hat es sich als ausreichend erwiesen, wenn die Positioniereinrichtung einen Anschlag umfasst, gegen den der individuelle Halter beim Drehen und/oder Wenden stößt. Insbesondere in Kombination mit der o.a. Rutschkupplung bzw. Reibeinrichtung ist mit hinreichender Sicherheit gewährleistet, dass sich der Gegenstand (bzw. das optische Element) an der gewünschten Stelle und in der gewünschten Lage, respektive Ausrichtung, befindet. Eine derartige Ausführung ist vergleichsweise wenig störanfällig, einfach in der Herstellung und damit kostengünstig.

In vielen Fällen ist es hilfreich, wenn die Positioniereinrichtung aktivierbar und deaktivierbar ist. So kann es vorteilhaft sein, wenn der Gegenstand (das optische Element oder das nichtoptische Element) einen oder mehrere Dreh- und/oder Wendevorgänge ungehindert ausführen kann und erst ab einem bestimmten Zeitpunkt oder bei Eintritt eines bestimmten Ereignisses in einer bestimmten Position festgesetzt wird oder eine vorbestimmte Position einnimmt. Derartige Rotationsbewegungen sind insbesondere zur Beschichtung von Werkzeugen wie Bohrern oder dergleichen mit z.B. tribologischen Materialien vorteilhaft.

Vielfach ist es günstig, eine Arretiereinrichtung vorzusehen, um den positionierten individuellen Halter in der vorbestimmten Position zu arretieren. Dies ist insbesondere dann günstig, wenn Kräfte oder Momente auf das z.B. zu beschichtende optische Element oder den Halter einwirken können, welche geeignet sind, das optische Element aus seiner vorgesehenen Lage zu verbringen.

In einer besonders vorteilhaften Ausgestaltung der Erfindung ist vorgesehen, dass der individuelle Antrieb eine individuelle vakuumtaugliche Ansteuer- und/oder Regeleinrichtung umfasst. Es kann auch vorgesehen sein, dass der individuelle Antrieb eine universelle (zur Ansteuerung und/oder Regelung mehrerer Motoren vorgesehene) und vakuumtaugliche Ansteuer- und/oder Regeleinrichtung umfasst. Ansteuer- und/oder Regeleinrichtung können dann in beiden Fällen innerhalb der Vakuumanlage angeordnet sein. Es sind ggf. lediglich elektrische Anschlüsse herauszuführen. Für manche Einsatzzwecke mag es vorteilhaft sein, selbst die Energieversorgung innerhalb der Vakuumkammer anzuordnen. Diese kann einer einzigen erfindungsgemäßen Vorrichtung zugeordnet sein oder auch mehreren.

Ein individueller Antrieb der erfindungsgemäßen Art kann einen Elektromotor oder einen elektrischen Aktuator umfassen. Dieser kann unmittelbar an dem Halter angebracht sein. Der bzw. die Elektromotoren können für den hier vorgestellten Zweck vakuumtauglich gestaltet werden und sind damit besonders geeignet. Anstelle eines Elektromotors oder elektrischen Aktuators sind auch andere Motoren oder Aktuatoren denkbar, wenn sie autark betrieben werden können.

Der eingesetzte Elektromotor ist bevorzugt ein Schrittmotor. Schrittmotoren zeichnen sich dadurch aus, dass sie bei geeigneter Ansteuerung oder Regelung sehr präzise eine gewünschte Position einnehmen oder eine gewünschte Rotation bzw. Drehbewegung durchführen können.

Der Elektromotor kann auch ein Linearmotor sein. Die Verwendung eines Linearmotors kann wegen des einfachen mechanischen Aufbaus kostengünstiger und ggf auch weniger störanfällig sein als ein Rotationsmotor.

Die Umsetzung der Linearbewegung in eine zum Drehen oder Wenden erforderliche Drehbewegung ist für den Fachmann trivial. Es kann gemäß der Erfindung eine Transformationseinrichtung zum Transformieren der Linearbewegung des Linearmotors in eine Dreh- und/oder Wendebewegung vorgesehen sein. Die Transformationseinrichtung kann eine Zahnstange und ein mit dieser zusammenwirkendes Zahnrad umfassen.

Besonders vorteilhaft ist es, wenn der Elektromotor ein piezoelektrischer Miniaturmotor ist. Piezoelektrische Miniaturmotoren sind aus dem Stand der Technik in vielfachsten Ausführungen bekannt. Varianten sind z.B. aus der DD 293694 A5, der DE 34 33 768 A1, der DE 44 38 876 A1, der EP 0 767 504 B1 oder der WO 2006/018062 A1 bekannt. Bei diesen handelt es sich allesamt um rotierende piezoelektrische Miniaturmotoren.

Als besonders günstig hat sich eine Variante eines z.B. in den Dokumenten EP1630879 A2, EP1594175 A2, EP1520338 A2, US 6,664,714 B2, US 6,690,101 B2 oder US 6,870,304 B2 beschriebenen piezoelektrischen Miniaturmotors herausgestellt, welche sowohl eine Drehbewegung als auch eine lineare Bewegung erzeugen kann. Das Funktionsprinzip des Miniatur-Motors oder Miniatur-Aktuators beruht auf dem inversen Piezoeffekt. Ein Microcontroller sowie zwei winzige Transistoren genügen, um die Piezokeramik mit der nötigen elektrischen Spannung zu versorgen. Diese dehnt sich nach dem Einschalten um weniger als einen Mikrometer aus und zieht sich nach dem Abschalten wieder zusammen. Während des Betriebs findet dieses Wechselspiel etwa 100.000 Mal in der Sekunde statt. Mit Hilfe der Bewegung der Piezokeramik wird der Resonator zum Schwingen angeregt und in Resonanz gebracht. Die Form des Resonators wurde so weit optimiert, dass die Schwingungen der Piezokeramik verstärkt und in ellipsenförmige Bewegungen umgewandelt werden. Mit einer Feder wird die auf einer elliptischen Kreisbahn schwingende Motorspitze gegen das anzutreibende Element gedrückt, welches mit jeder Schwingung um wenige Mikrometer weiter geschoben wird. Durch periodische Wiederholungen entsteht eine gleichförmige, kontinuierliche Bewegung. Dabei ist der Miniatur-Motor/Miniatur-Aktuator ein Antrieb auf Basis der Piezotechnologie, welcher eine Vorwärts- und Rückwärtsbewegung mit nur einer Piezokeramik realisiert.

Vorzugsweise steht der piezoelektrische Miniaturmotor mit seiner elliptisch schwingenden Motorspitze in reibschlüssiger Verbindung mit einem Reibrad und/oder einer Reibstange. Die Bewegung des Reibrads kann dann direkt oder über ein Getriebe zum Drehen und/oder Wenden des Gegenstands, vorzugsweise des optischen Elements, verwendet werden. Die Reibstange kann in der Art einer Zahnstange ausgebildet sein, um ihre lineare Bewegung in eine Drehbewegung umzusetzen.

Wie oben bereits angedeutet wurde, ist in einer besonders vorteilhaften Ausführungsvariante eine Befestigungseinrichtung zum vorzugsweise lösbaren Befestigen an einer Kalotte vorgesehen. Damit lassen sich eine Mehrzahl an Gegenständen, wie optischen Elementen, gleichzeitig oder zeitlich versetzt innerhalb der Vakuumbeschichtungsanlage drehen und/oder wenden.

Die Befestigungseinrichtung kann eine Justageeinrichtung umfassen, um die Position der Vorrichtung in Bezug auf die Kalotte festzulegen. Diese Maßnahme mag in vielen Fällen entbehrlich sein, wenn jedoch besonders definierte Schichtdicken abgeschieden werden sollen, kann auf eine Justage nicht verzichtet werden.

Es hat sich als sehr günstig herausgestellt, wenn der individuelle Halter Klebestellen, insbesondere maximal zwei Klebestellen, aufweist, an welchen der Gegenstand (das optische Element) anklebbar ist. Details zur Fixierung eines optischen Elements am Halter sowie die entsprechenden Vorteile entnimmt man der internationalen Patentanmeldung PCT/EP2006/000573.

Ein Verfahren zum Halten sowie zum Drehen und/oder Wenden eines Gegenstands, insbesondere eines optischen Elements wie z.B. einer Linse oder eines nichtoptischen Gegenstands, wie z.B. eines Bohrers, bei dessen Beschichtung in einer Vakuumbeschichtungsanlage, wobei der Gegenstand (also das optische oder nichtoptische Element) mit einem individuellen Halter für den Gegenstand (das optische oder nichtoptische Element) gehalten wird, zeichnet sich gemäß der Erfindung dadurch aus, dass der individuelle Halter mit einem dem individuellen Halter zugeordneten individuellen Antrieb oder mit mehreren dem individuellen Halter zugeordneten individuellen Antrieben gedreht und/oder gewendet wird. Die Vorteile, die sich aus einem derartigen Verfahren ergeben wurden vorstehend zu der erfindungsgemäßen Vorrichtung bereits genannt.

Die Vorrichtung kann während des Betriebs der Vakuumbeschichtungsanlage zum Drehen und/oder Wenden angetrieben werden. Dieser Vorgang kann vor Beginn oder nach Abschluss eines Beschichtungsvorgangs erfolgen, es ist jedoch auch möglich, die Vorrichtung zum Drehen und/oder Wenden während der Beschichtung anzutreiben.

Es ist sogar möglich, die Vorrichtung kontinuierlich anzutreiben. Dies ist insbesondere bei der Abscheidung tribologischer Schichten z.B. auf einen Bohrer günstig.

Es ist vorgesehen, bei der Beschichtung (durch Verdampfung, Sputtern, chemische Gasphasenabscheidung oder dergleichen) optische Funktionsschichten (wie z.B. Antireflexschichten) oder nichtoptische Funktionsschichten (wie z.B. Antihaftschichten, insbesondere auch schmutzabweisende Schichten)) aufzubringen. Weiter können ganz allgemein tribologische Funktionsschichten, nämlich reibungsmindemde oder reibungsvergrößernde Schichten oder Verschleißschutzschichten auf verschiedenste Materialien (Werkzeugteile, Anlagenkomponenten etc.) unter Nutzung der Rotationsbewegung / Wendemöglichkeit aufgebracht werden.

Beim Aufbringen von Mehrschichtsystemen ist erfindungsgemäß -wie oben bereits angedeutet- vorgesehen, zunächst die Vorder- und Rückseite des Gegenstands (des optischen oder nichtoptischen Elements) mit einer gleichen (jedoch nicht zwingend mit identischer Dicke) Schicht zu versehen und in einem nachfolgenden Schritt eine andere Schicht aufzubringen. Hierdurch verhindert man den z.B. beim Verdampfen von Materialien negativen Effekt von Hinterdampfungen, der auftritt, wenn die Gegenstände (optischen oder nichtoptischen Elemente) zunächst auf einer Seite mit mehreren Schichten unterschiedlichen Materials versehen werden, dann die Kalotte ausgeschleust wird, die Gegenstände (optischen oder nichtoptischen Elemente) gewendet und dann auf die zweite Seite der Gegenstände (optischen oder nichtoptischen Elemente) ggf. mehrere Schichtlagen aufgebracht werden.

Die Erfindung wird nunmehr anhand der Zeichnung näher beschrieben. Gleiche oder funktionsgleiche Komponenten sind in allen Figuren mit identischen Bezugszeichen gekennzeichnet. Die Zeichnungen beziehen sich allein auf Halter für Linsen. Es dürfte dem Fachmann jedoch leicht einleuchtend sein, dass ein derartiger Halter (ggf. mit leicht modifizierter Geometrie) auch für andere Gegenstände eingesetzt werden kann. Es zeigen:
- Figur 1:: Ein erstes Ausführungsbeispiel einer erfindungsgemäßen Halte- und Wendevorrichtung für eine Linse in perspektivischer Darstellung.
- Figur 2:: Einen Ausschnitt aus einem mit mehreren Halte- und Wendevorrichtungen gemäß Figur 1 versehenden Kalottensegment in perspektivischer Darstellung.
- Figur 3:: Ein zweites Ausführungsbeispiel einer Halte- und Wendevorrichtung für eine Linse gemäß der Erfindung in Form eines Direktantriebs in perspektivischer Darstellung.
- Figur 4:: Ein drittes Ausführungsbeispiel einer erfindungsgemäßen Halte- und Wendevorrichtung gemäß der Erfindung in Form eines Zahnstangenantriebs in perspektivischer Darstellung.
- Figur 5:: Ein viertes Ausführungsbeispiel einer erfindungsgemäßen Halte- und Wendevorrichtung mit Stirnradgetriebe in perspektivischer Darstellung.
- Figur 6:: Ein Ausführungsbeispiel eines Planeten-Kugelgetriebes zur Verwendung für ein Halte- und Wendevorrichtung für eine Linse gemäß der Erfindung in perspektivischer Darstellung.
- Figur 7:: Ein fünftes Ausführungsbeispiel einer Halte- und Wendevorrichtung für eine Linse mit einer Getriebebox "Harmonic Drive" (Perspektivdarstellung).
- Figur 8:: Ein sechstes Ausführungsbeispiel einer Halte- und Wendevorrichtung für eine Linse mit mehreren Motoren/Aktuatoren im Direktantrieb mittels mitschwenkendem Drehhebel in perspektivischer Darstellung.

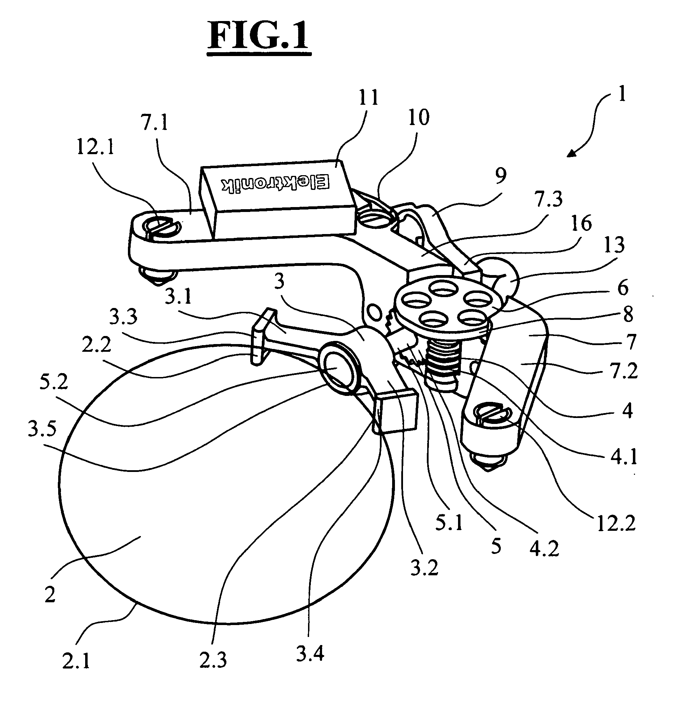

Die Figur 1 zeigt ein erstes Ausführungsbeispiel einer Halte- und Wendevorrichtung 1 für eine Linse 2 gemäß der Erfindung. Die Halte- und Wendevorrichtung 1 umfasst einen Linsenhalter 3, welcher zum Halten einer einzigen Brillenlinse 2 vorgesehen ist. Der Linsenhalter 3 weist zwei winklig abstehende Arme 3.1, 3.2 auf. Diese winklig abstehenden Arme 3.1, 3.2 sind endseitig kopfartig verdickt. Diese kopfartigen Verdickungen dienen als Anlageflächen 3.3, 3.4 für die vom Linsenhalter 3 zu haltende Linse 2. Die Linse 2 ist im vorliegenden Ausführungsbeispiel kreisrund ausgeführt. Sie könnte jedoch auch jegliche andere Form aufweisen. An ihrem Linsenrand 2.1 liegt die Brillenlinse 2 punktartig auf den beiden Anlageflächen 3.3, 3.4 der kopfartig verdickten Arme 3.1, 3.2 auf. Diese Anlageflächen 3.3, 3.4 stellen Klebestellen 2.2., 2.3 dar, an welchen die Brillenlinse 2 mit dem Linsenhalter 3 verklebt ist. Einzelheiten zur Ausgestaltung des Linsenhalters 3 als solcher gehen aus der internationalen Patentanmeldung PCT/EP2006/000573 bzw. der prioritätsgleichen deutschen Patentanmeldung mit der Anmeldenummer 10 2005 004006.3 hervor.

Der Linsenhalter 3 weist mittig eine Öffnung 3.5 auf. Diese Öffnung 3.5 dient als Aufnahme eines Zapfens 5.2 einer Abtriebswelle 5.1. Zapfen 5.2 und Öffnung 3.5 sind formkomplementär ausgebildet, so dass eine formschlüssige und wahlweise kraftschlüssige und/oder lagedefinierte Verbindung zwischen der Abtriebswelle 5.1 und dem Linsenhalter 3 besteht.

Diese Abtriebswelle 5.1 ist über ein nachfolgend im Detail beschriebenes Getriebe mit einem elektromotorischen Antrieb in Form eines Miniatur-Piezo-Motors 9 verbunden. Dieser Piezo-Motor 9 ist ebenso wie das Getriebe an einem Befestigungsbügel 7 angebracht.

Der Miniatur-Piezo-Motor 9 umfasst eine Piezokeramik welche mit einer Frequenz von etwa 100 kHz elektrisch angesteuert wird. Mit dieser Frequenz dehnt sich die Piezokeramik beim Einschalten um weniger als einen Mikrometer aus und zieht sich nach dem Abschalten wieder zusammen. Die Piezokeramik treibt gegen die Kraft einer Feder 10 den Piezo-Aktuator 9 derart an, dass dessen Motorspitze 16 eine elliptische Bahn beschreibt. Die Motorspitze 16 ist in reibschlüssiger Verbindung mit einem Reibrad 6, welches mit jeder Schwingung um wenige Mikrometer weiter gedreht wird. Die hohe Antriebsfrequenz von etwa 100 kHz führt in Verbindung mit dem elliptischen Hub der schwingenden Motorspitze 16 und dem Reibschluss zwischen der Motorspitze 16 und dem Reibrad 6 zu einer Drehung des Reibrads 6 mit einer Umfangsgeschwindigkeit von mehreren Zentimetern pro Sekunde.

Das Reibrad 6 ist an dem Befestigungsbügel 7 drehbar gelagert. Über eine drehfeste Verbindung zwischen dem Reibrad 6 und einer Schnecke 4.1 wird die Drehbewegung des Reibrads 6 auf das Stirnzahnrad 4.2 übertragen, welches mit der Schnecke 4.1 des Schneckengetriebes 4 in Eingriff ist. Das Stirnzahnrad 4.2 ist wiederum mit der Abtriebswelle 5.1 des Abtriebs 5 mit Form- und/oder Kraftschluss drehfest verbunden, so dass die Drehbewegung des Reibrads 6 auch auf den Linsenhalter 3 übertragen wird und die Brillenlinse 2 eine Wendebewegung vollzieht.

Durch einfache Änderung des Getriebes könnte auch eine Drehbewegung um eine Achse erzeugt werden, welche beispielsweise senkrecht zu der durch die beiden Arme 3.1, 3.2 des Linsenhalters 3 aufgespannte Ebene steht.

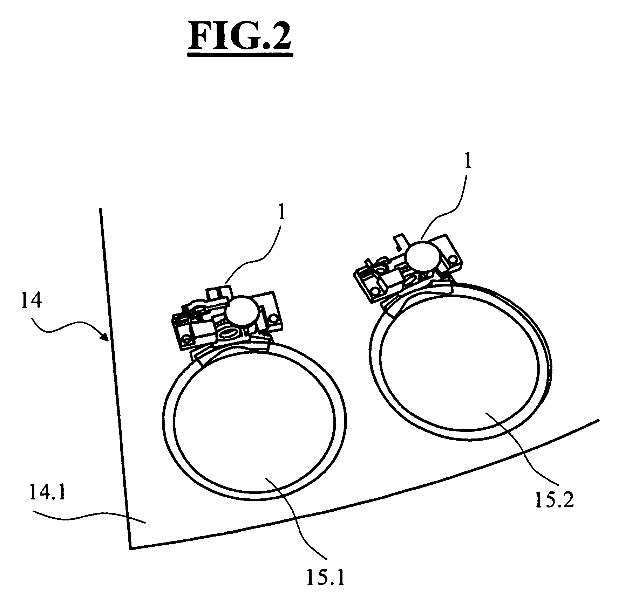

Der Befestigungsbügel 7 weist zum Befestigen an einem Träger eine Befestigungseinrichtung, hier z.B. in Form eines Kugelbolzens 13 auf, welcher im vorliegenden Ausführungsbeispiel senkrecht von der Traverse 7.3 des Befestigungsbügels 7 absteht. Dieser Befestigungsbolzen 13 kann in eine in dem Träger vorgesehene Öffnung eingeführt werden und dort beispielsweise verrastet werden. Mehrere Halte- und Wendevorrichtungen 1 der eben beschriebenen Art können beispielsweise wie in der Figur 2 dargestellt ist, an einem Kalottensegment 14.1 einer Kalotte 14 befestigt sein. Die Linsenhalter 3 ragen dabei zusammen mit den jeweiligen Brillenlinsen 2 in entsprechende Öffnungen 15.1, 15.2 der Kalotte hinein.

Um die Halte- und Wendevorrichtung 1 in Bezug auf die Orientierung der Öffnung 15.1, 15.2 der Kalotte 14 justieren zu können, sind endseitig an zwei winklig von der Traverse 7.3 des Befestigungsbügels 7 abstehenden Armen 7.1, 7.2 Justageschrauben 12.1, 12.3 vorgesehen, welche mit der Kalotte 14 zur Anlage gebracht werden können.

Die Halte- und Wendevorrichtung 1 kann in Bezug auf die Öffnung 15.1, 15.2 der Kalotte 14 derartig angeordnet sein, dass diese als Anlagefläche für die jeweiligen Enden der Arme 3.1, 3.2 des Linsenhalters 3 dient. Auf diese Weise kann der Wendevorgang anschlagbegrenzt werden. Eine ZerstÖrung der Anordnung ist nicht zu befürchten, da der Krafteintrag durch den Piezo-Aktuator 9 durch Reibschluss auf die Reibscheibe 6 erfolgt. Am Anschlag rutscht die Motorspitze 16 lediglich am Umfang des Reibrads 6 durch.

Gemäß der Erfindung ist vorgesehen, dass nicht nur der piezoelektrische Antrieb als solcher innerhalb der Vakuumbeschichtungsanlage angeordnet ist, sondern bevorzugt sogar die zugehörige Ansteuerelektronik 11. Diese befindet sich beispielsweise auf einem der Arme 7.1 des Befestigungsbügels 7. Es ist sogar möglich, die elektrische Energieversorgung innerhalb der Vakuumbesehichtungsanlage vorzusehen, wenn man die hierfür vorgesehene Energiequelle vakuumtauglich gestaltet.

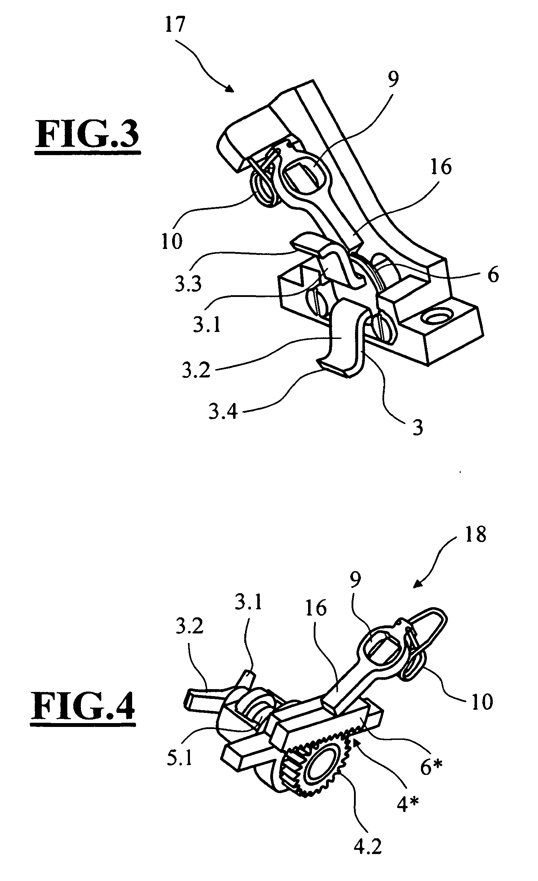

Die Figur 3 zeigt ein weiters Ausführungsbeispiel einer erfindungsgemäßen Halte- und Wendevorrichtung 17. Bei diesem in der Figur 3 dargestellten Ausführungsbeispiel ist kein zusätzliches Getriebe vorgesehen. Vielmehr ist das Reibrad 6, welches von der Motorspitze 16 durch die Feder 10 unterstützten Piezo-Aktuators 9 angetrieben wird, Bestandteil des Linsenhalters 3.

Figur 4 zeigt ein drittes Ausführungsbeispiel einer erfindungsgemäßen Halte-und Wendevorrichtung 18. Bei dieser Halte- und Wendevorrichtung 18 ist das Reibrad 6 gemäß der Figur 3 durch einen Reibstange 6* ersetzt. Die Reibstange 6* ist zugleich als Zahnstange ausgebildet, welche mit einem Stirnradzahnrad 4.2 in Wirkeingriff ist. Das Stirnzahnrad 4.2 ist wiederum drehfest mit der Abtriebswelle 5.1 verbunden, welche ebenfalls drehfest mit dem eigentlichen Linsenhalter 3 mit seinen beiden Armen 3.1, 3.2 verbunden ist.

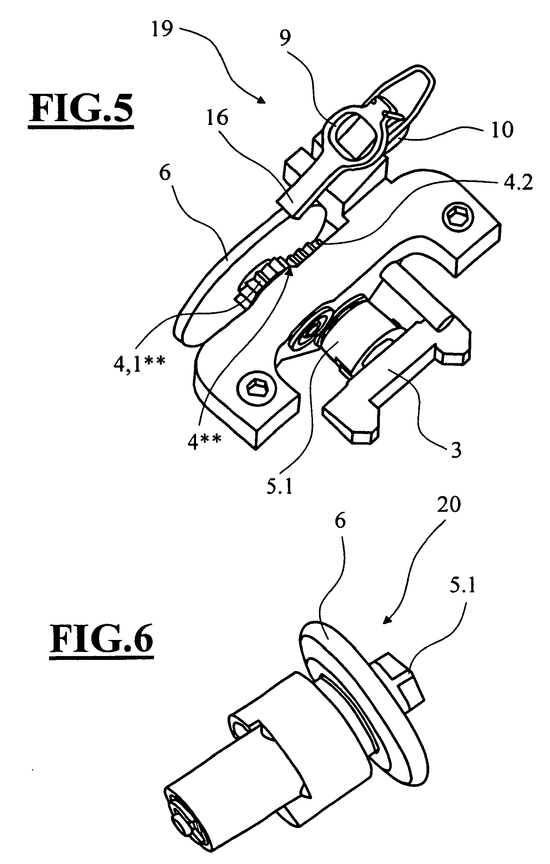

Die Figur 5 zeigt ein viertes Ausführungsbeispiel einer erfindungsgemäßen Halte- und Wendevorrichtung 19. Dieses Ausführungsbeispiel ist sehr ähnlich zu dem gemäß der Figur 1 ausgeführt. Anstelle des in der Figur 1 vorgesehen Schneckengetriebes 4 ist ein Stirnradgetriebe 4** vorgesehen. Die Schnecke 4.1 ist durch ein Stirnzahnrad 4.1** ersetzt.

Die möglicherweise notwendige Kraft- / Drehmomentverstärkung kann auch über geeignete andere Getriebe erfolgen. Die Verwendung jeglicher Stirnrad-, Schnecken-, Planeten-, Kugelgetriebe oder auch Harmonic Drive-Getriebe ist grundsätzlich möglich.

Die Figur 6 zeigt ein Ausführungsbeispiel eines Antriebs 20 mit Planeten-Kugelgetriebe. Gezeigt ist wiederum das eingangsseitige Reibrad 6 und die ausgangsseitige Abtriebswelle 5.1.

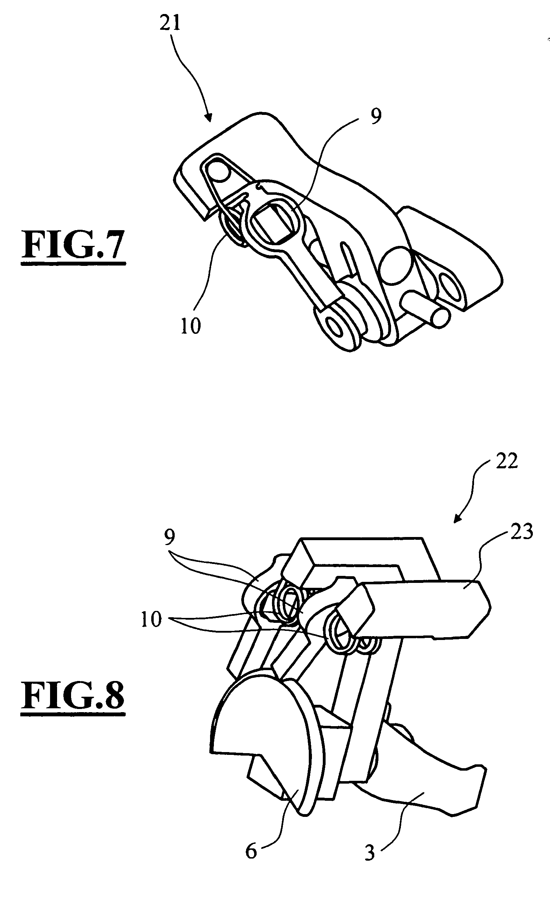

Die Figur 7 zeigt ein weiters Ausführungsbeispiel eines Antriebs 21 mit Getriebebox "Harmonic Drive" zum Antrieb einer erfindungsgemäßen Vorrichtung zum Halten und Drehen und/oder Wenden eines optischen Elements.

Die Figur 8 zeigt ein weiteres Ausführungsbeispiel eines Antriebs 22 unter Verwendung mehrerer Piezoantriebe 9 zur Kraft-/Drehmomentverstärkung an einem Ausleger bzw. Hebel 23 montiert. Hierbei ist der als Haltearm dienende Ausleger 23 drehbar gelagert, dies ermöglicht dem oder den Motoren/Aktuatoren 9 sich mit dem Haltearm 23 und dem am Haltearm 23 drehfest verbundenem Halter 3 zu drehen. Dabei kann das Reibrad 6 sowohl fest (insbesondere drehfest), als auch beweglich ausgeführt sein. Ein Getriebe zur Übersetzung ins Schnelle (nicht dargestellt) kann nach Anforderung mit integriert werden.

### Bezugszeichenliste

- 1: Halte- und Wendevorrichtung für eine Linse
- 2: Brillenlinse
- 2.1: Linsenrand
- 2.2: Klebestelle
- 2.3: Klebestelle
- 3: Linsenhalter
- 3.1: Arm
- 3.2: Arm
- 3.3: Anlagefläche
- 3.4: Anlagefläche
- 3.5: Öffnung
- 4: Schneckengetriebe
- 4*: Zahnstangengetriebe
- 4**: Stirnradgetriebe
- 4.1: Schnecke
- 4.1**: Stirnzahnrad
- 4.2: Stirnzahnrad
- 5: Abtrieb mit Formschluss
- 5.1: Abtriebswelle
- 5.2: Zapfen
- 6: Reibrad
- 6*: Reibstange/Zahnstange
- 7: Befestigungsbügel
- 7.1: Arm
- 7.2: Arm
- 7.3: Traverse
- 8: Lager
- 9: Piezo-Aktuator
- 10: Feder
- 11: Motorsteuerung
- 12.1: Justageschraube
- 12.2: Justageschraube
- 13: Befestigungsbolzen
- 14: Kalotte
- 14.1: Kalottensegment
- 15.1: Öffnung
- 15.2: Öffnung
- 16: Motorspitze
- 17: Direktantrieb
- 18: Zahnstangenantrieb
- 19: Antrieb mit Stirnradgetriebe
- 20: Antrieb mit Planeten-Kugelgetriebe.
- 21: Antrieb mit Getriebebox Harmonic Drive
- 22: multipler Direktantrieb
- 23: Ausleger

## Patentansprüche

1. Vakuumbeschichtungsanlage für optische Elemente wie z.B. Linsen (2) oder nicht optische Elemente wie z.B. Werkzeuge mit einer Vorrichtung (1, 17, 18, 19, 22) zum Halten sowie zum Drehen und/oder Wenden von Elementen mit einem individuellen Halter (3) für jedes Element (2) **dadurch gekennzeichnet, dass** jedem individuellen Halter (3) wenigstens ein individueller Antrieb (9) zum Drehen und/oder Wenden zugeordnet ist.

2. Vakuumbeschichtungsanlage nach Anspruch 1, **dadurch gekennzeichnet, dass** der wenigstens eine individuelle Antrieb (9) als Direktantrieb (17, 22) ausgeführt ist.

3. Vakuumbeschichtungsanlage nach Anspruch 1, **dadurch gekennzeichnet, dass** der wenigstens eine individuelle Antrieb (9) ein Getriebe (4, 4*, 4**, 20, 21) umfasst.

4. Vakuumbeschichtungsanlage nach Anspruch 3, **dadurch gekennzeichnet, dass** das Getriebe ein Zahnstangengetriebe (4*) und/oder ein Stirnradgetriebe (4**) und/oder ein Schneckengetriebe (4) und/oder ein Planetengetriebe (20) und/oder ein Kugelgetriebe (20) und/oder ein Harmonic Drive Getriebe (21) umfasst.

5. Vakuumbeschichtungsanlage nach einem der vorangegangenen Ansprüche, **dadurch gekennzeichnet, dass** eine die Antriebskraft und/oder das Antriebsmoment des wenigstens einen individuellen Antriebs (9) auf den individuellen Halter (3) übertragende Reibeinrichtung (6) vorgesehen ist.

6. Vakuumbeschichtungsanlage nach einem der vorangegangenen Ansprüche, **dadurch gekennzeichnet, dass** der individuelle Halter (3) und der wenigstens eine individuelle Antrieb (3) mittelbar oder unmittelbar formschlüssig und/oder kraftschlüssig und/oder geometrisch lageorientiert miteinander verbindbar sind

7. Vakuumbeschichtungsanlage nach einem der vorangegangenen Ansprüche, **dadurch gekennzeichnet, dass** eine Positioniereinrichtung (14) vorgesehen ist, um den individuellen Halter (3) beim Drehen und/oder Wenden in eine vorbestimmte Position zu verbringen.

8. Vakuumbeschichtungsanlage nach Anspruch 7, **dadurch gekennzeichnet, dass** die Positioniereinrichtung einen Anschlag umfasst, gegen den der individuelle Halter (3) beim Drehen und/oder Wenden stößt.

9. Vakuumbeschichtungsanlage nach Anspruch 8, **dadurch gekennzeichnet, dass** die Positioniereinrichtung aktivierbar und/oder deaktivierbar ist.

10. Vakuumbeschichtungsanlage nach einem der Ansprüche 7 bis 9, **dadurch gekennzeichnet, dass** eine Arretiereinrichtung vorgesehen ist, um den positionierten individuellen Halter (3) in der vorbestimmten Position zu arretieren.

11. Vakuumbeschichtungsanlage nach einem der vorangegangenen Ansprüche, **dadurch gekennzeichnet, dass** der wenigstens eine individuelle Antrieb (9) eine individuelle oder universelle vakuumtaugliche Ansteuer- oder und/oder Regeleinrichtung (11) umfasst.

12. Vakuumbeschichtungsanlage nach einem der vorangegangenen Ansprüche, **dadurch gekennzeichnet, dass** der wenigstens eine individuelle Antrieb (9) einen Elektromotor (9) oder mehrere Elektromotoren (9) umfasst und/oder dass der wenigstens eine individuelle Antrieb (9) einen elektrischen Aktuator (9) oder mehrere elektrische Aktuatoren (9) umfasst.

13. Vakuumbeschichtungsanlage nach Anspruch 12, **dadurch gekennzeichnet, dass** der Elektromotor ein Schrittmotor ist bzw. dass die Elektromotoren Schrittmotoren sind.

14. Vakuumbeschichtungsanlage nach Anspruch 12 oder 13, **dadurch gekennzeichnet, dass** der Elektromotor ein Linearmotor (9, 6^{*}) ist bzw. dass die Elektromotoren Linearmotoren (9) sind.

15. Vakuumbeschichtungsanlage nach Anspruch 14, **dadurch gekennzeichnet, dass** eine Transformationseinrichtung (⁴*) zum Transformieren der Linearbewegung des Linearmotors (9, 6^{*}) bzw. der Linearmotoren (9) in eine Dreh- und/oder Wendebewegung vorgesehen ist.

16. Vakuumbeschichtungsanlage nach Anspruch 15, **dadurch gekennzeichnet, dass** die Transformationseinrichtung (4^{*}) eine Zahnstange (6^{*}) und eine mit dieser zusammenwirkendes Zahnrad (4.2) umfasst.

17. Vakuumbeschichtungsanlage nach einem der Ansprüche 12 bis 16, **dadurch gekennzeichnet, dass** der Elektromotor ein piezoelektrischer Miniaturmotor (9) ist bzw. dass die Elektromotoren piezoelektrische Miniaturmotoren (9) sind und/oder dass der elektrische Aktuator ein piezoelektrischer Aktuator (9) ist bzw. dass die elektrischen Aktuatoren piezoelektrische Aktuatoren (9) sind.

18. Vorrichtung nach Anspruch 17, **dadurch gekennzeichnet, dass** der piezoelektrische Miniaturmotor (9) eine elliptisch schwingende Motorspitze (16) aufweist, welche in reibschlüssiger Verbindung mit einem Reibrad (6) und/oder einer Reibstange (6^{*}) steht.

19. Vakuumbeschichtungsanlage nach einem der vorangegangenen Ansprüche, **dadurch gekennzeichnet, dass** eine Befestigungseinrichtung (7) zum Befestigen an einer Kalotte (14) vorgesehen ist.

20. Vakuumbeschichtungsanlage nach einem der vorangegangenen Ansprüche, **dadurch gekennzeichnet, dass** eine Befestigungseinrichtung (7) zum lösbaren Befestigen an einer Kalotte (14) vorgesehen ist.

21. Vakuumbeschichtungsanlage nach Anspruch 19 oder 20, **dadurch gekennzeichnet, dass** die Befestigungseinrichtung (7) eine Justageeinrichtung (12.1, 12.2) umfasst, um die Position der Vorrichtung in Bezug auf die Kalotte (14) festzulegen.

22. Vakuumbeschichtungsanlage nach einem der vorangegangenen Ansprüche, **dadurch gekennzeichnet, dass** der individuelle Halter (3) Klebestellen (2.2, 2.3), insbesondere maximal zwei Klebestellen (2.2, 2.3), aufweist, an welchen das optische Element (2) anklebbar ist.

23. Vakummbeschichtungsanlage nach einem der vorangegangenen Ansprüche mit einer Kalotte (14), welche mit einer Mehrzahl an Vorrichtungen (1, 17, 18, 19) bestückt ist.

24. Verfahren zum Halten sowie zum Drehen und/oder Wenden optischer Elemente wie z.B. Linsen (2), oder nichtoptischer Elemente, wie z.B. Werkzeuge, bei deren Beschichtung in einer Vakuumbeschichtungsanlage nach einem der Ansprüche 1-23, wobei jedes Element (2) mit einem individuellen Halter (3) gehalten wird, **dadurch gekennzeichnet, dass** jeder individuelle Halter (3) mit wenigstens einem dem individuellen Halter (3) zugeordneten individuellen Antrieb (9) gedreht und/oder gewendet wird.

25. Verfahren nach Anspruch 24 **dadurch gekennzeichnet, dass** die Vorrichtung (1, 17, 18, 19) während des Betriebs der Vakuumbeschichtungsanlage gedreht und/oder gewendet wird.

26. Verfahren nach einem der Ansprüche 24 bis 25, **dadurch gekennzeichnet, dass** die Vorrichtung (1, 17, 18, 19) während der Beschichtung des Elements (2) zum Drehen und/oder Wenden angetrieben wird.

27. Verfahren nach einem der Ansprüche 24 bis 26, **dadurch gekennzeichnet, dass** die Vorrichtung (1, 17, 18, 19) kontinuierlich zum Drehen und/oder Wenden angetrieben wird.

28. Verfahren nach einem der Ansprüche 24 bis 27, **dadurch gekennzeichnet, dass** bei der Beschichtung eine Funktionsschicht aufgebracht wird.

29. Verfahren nach Anspruch 28, **dadurch gekennzeichnet, dass** die Funktionsschicht eine tribologisch wirksame Schicht umfasst.

30. Verfahren nach einem der Ansprüche 24 bis 29, **dadurch gekennzeichnet, dass** das Aufbringen von Mehrschichtsystemen auf die Vorder- und Rückseite des Elements (2) **dadurch** erfolgt, dass eine Schicht zunächst auf Vorder- und Rückseite aufgebracht wird, bevor die nächste Schicht aufgebracht wird.

## Claims

1. Vacuum coating system for optical elements such as, for example, lenses (2) or non-optical elements such as, for example, tools, having an apparatus (1, 17, 18, 19, 22) that is for holding as well as for rotating and/or turning elements with the aid of an individual holder (3) for each element (2), **characterized in that** each individual holder (3) is assigned at least one individual drive (9) for rotating and/or turning.

2. Vacuum coating system according to Claim 1, **characterized in that** the at least one individual drive (9) is designed as a direct drive (17, 22).

3. Vacuum coating system according to Claim 1, **characterized in that** the at least one individual drive (9) comprises a transmission (4, 4*, 4**, 20, 21).

4. Vacuum coating system according to Claim 3, **characterized in that** the transmission comprises a rack gear (4^{*}) and/or a spu gear set (4^{**}) and/or a worm gear (4) and/or an epicyclic gear (20) and/or a ball gear (20) and/or a harmonic drive gear (21).

5. Vacuum coating system according to one of the preceding claims, **characterized in that** a friction device (6) is provided which transmits the driving force and/or the driving torque of at least one individual drive (9) to the individual holder (3).

6. Vacuum coating system according to one of the preceding claims, **characterized in that** the individual holder (3) and the at least one individual drive (3) can be interconnected indirectly or directly in the positive and/or non-positive and/or geometrically positionally orientated fashion.

7. Vacuum coating system according to one of the preceding claims, **characterized in that** a positioning device (14) is provided in order to transfer the individual holder (3) into a predetermined position in the event of rotating and/or turning.

8. Vacuum coating system according to Claim 7, **characterized in that** the positioning device comprises a stop against which the individual holder (3) strikes in the event of rotating and/or turning.

9. Vacuum coating system according to Claim 8, **characterized in that** the positioning device can be activated and/or deactivated.

10. Vacuum coating system according to one of Claims 7 to 9, **characterized in that** a locking device is provided for locking the positioned individual holder (3) in the predetermined position.

11. Vacuum coating system according to one of the preceding claims, **characterized in that** the at least one individual drive (9) comprises an individual or universal vacuum-compatible drive device and/or control device (11).

12. Vacuum coating system according to one of the preceding claims, **characterized in that** the at least one individual drive (9) comprises an electric motor (9) having a plurality of electric motors (9), and/or in that the at least one individual drive (9) comprises an electric actuator (9) or a plurality of electric actuators (9).

13. Vacuum coating system according to Claim 12, **characterized in that** the electric motor is a stepping motor, or the electric motors are stepping motors.

14. Vacuum coating system according to Claim 12 or 13, **characterized in that** the electric motor is a linear motor (9, 6^{*}) or **in that** the electric motors are linear motors (9).

15. Vacuum coating system according to Claim 14, **characterized in that** a transformation device (4^{*}) is provided for transforming the linear movement of the linear motor (9, 6^{*}) or the linear motors (9) into a rotational and/or turning movement.

16. Vacuum coating system according to Claim 15, **characterized in that** the transformation device (4^{*}) comprises a rack (6^{*}) and a gearwheel (4.2) operating with the latter.

17. Vacuum coating system according to one of Claims 12 to 16, **characterized in that** the electric motor is a piezoelectric miniature motor (9) or that the electric motors are piezoelectric miniature motors (9), and/or that the electric actuator is a piezoelectric actuator (9) or that that electric actuators are piezoelectric actuators (9).

18. Apparatus according to Claim 17, **characterized in that** the piezoelectric miniature motor (9) has an elliptically vibrating motor tip (16) which is connected by friction engagement to a friction wheel (6) and/or a friction bar (6^{*}).

19. Vacuum coating system according to one of the preceding claims, **characterized in that** a fastening device (7) for fastening on a spherical cap (14) is provided.

20. Vacuum coating system according to one of the preceding claims, **characterized in that** a fastening device (7) for detachable fastening on a spherical cap (14) is provided.

21. Vacuum coating system according to Claim 19 or 20, **characterized in that** the fastening device (7) comprises an adjusting device (12.1, 12.2) for fixing the position of the apparatus with reference to the spherical cap (14).

22. Vacuum coating system according to one of the preceding claims, **characterized in that** the individual holder (3) has adhesive points (2.2, 2.3), in particular at most two adhesive points (2.2, 2.3), to which the optical element (2) can adhere.

23. Vacuum coating system according to one of the preceding claims, having a spherical cap (14) which is fitted with a plurality of apparatuses (1, 17, 18, 19).

24. Method for holding as well as for rotating and/or turning optical elements such as, for example, lenses (2), or non-optical elements such as, for example, tools, while such have been coated in a vacuum coating system according to one of claims 1-23, each element (2) being held with the aid of an individual holder (3), **characterized in that** each individual holder (3) is rotated and/or turned with the aid of at least one individual drive (9) assigned to the individual holder (3).

25. Method according to Claim 24, **characterized in that** the apparatus (1, 17, 18, 19) is rotated and/or turned during the operation of the vacuum coating system.

26. Method according to one of Claims 24 to 25, **characterized in that** the apparatus (1, 17, 18, 19) is driven to rotate and/or turn during the coating of the element (2).

27. Method according to one of Claims 24 to 26, **characterized in that** the apparatus (1, 17, 18, 19) is driven continuously to rotate and/or turn.

28. Method according to one of Claims 24 to 27, **characterized in that** a functional layer is applied during coating.

29. Method according to Claim 28, **characterized in that** the functional layer comprises a tribologically active layer.

30. Method according to one of Claims 24 to 29, **characterized in that** the application of multilayer systems on the front and rear sides of the element (2) is performed by firstly applying a layer to the front and rear sides before the next layer is applied.

## Revendications

1. Installation de revêtement sous vide pour des éléments optiques tels que par exemple des lentilles (2) ou des éléments non optiques tels que par exemple des outils, comprenant un dispositif (1, 17, 18, 19, 22) destiné à maintenir et tourner et/ou retourner des éléments comprenant un support (3) individuel pour chaque élément (2), **caractérisée en ce que** chaque support (3) individuel est associé à au moins un entraînement (9) individuel pour la rotation et/ou le retournement.

2. Installation de revêtement sous vide selon la revendication 1, **caractérisée en ce que** l'au moins un entraînement (9) individuel prend la forme d'un entraînement direct (17, 22).

3. Installation de revêtement sous vide selon la revendication 1, **caractérisée en ce que** l'au moins un entraînement (9) individuel comprend un engrenage (4, 4^{*}, 4^{**}, 20, 21).

4. Installation de revêtement sous vide selon la revendication 3, **caractérisée en ce que** l'engrenage comprend un engrenage à tige dentée (4^{*}) et/ou un engrenage à pignon fixe (4^{**}) et/ou un engrenage à vis sans fin (4) et/ou un engrenage planétaire (20) et/ou un engrenage à rotule (20) et/ou un engrenage à démultiplication harmonique (21).

5. Installation de revêtement sous vide selon l'une quelconque des revendications précédentes, **caractérisée en ce qu'**un dispositif de frottement (6) transmettant la force d'entraînement et/ou le couple d'entraînement de l'au moins un entraînement (9) individuel est prévu sur un support (3) individuel.

6. Installation de revêtement sous vide selon l'une quelconque des revendications précédentes, **caractérisée en ce que** le support (3) individuel et l'au moins un entraînement (3) individuel peuvent être reliés l'un à l'autre directement ou indirectement par complémentarité de formes et/ou par complémentarité de forces et/ou de façon orientée par rapport à la position d'un point de vue géométrique.

7. Installation de revêtement sous vide selon l'une quelconque des revendications précédentes, **caractérisée en ce qu'**un dispositif de positionnement (14) est prévu, pour amener le support (3) individuel dans une position prédéterminée lors de la rotation et/ou du retournement.

8. Installation de revêtement sous vide selon la revendication 7, **caractérisée en ce que** le dispositif de positionnement comprend une butée contre laquelle le support (3) individuel bute lors de la rotation et/ou du retournement.

9. Installation de revêtement sous vide selon la revendication 8, **caractérisée en ce que** le dispositif de positionnement peut être activé et/ou désactivé.

10. Installation de revêtement sous vide selon l'une quelconque des revendications 7 à 9, **caractérisée en ce qu'**un dispositif de blocage est prévu, pour bloquer le support (3) individuel positionné dans la position prédéfinie.

11. Installation de revêtement sous vide selon l'une quelconque des revendications précédentes, **caractérisée en ce que** l'au moins un entraînement (9) individuel comprend un dispositif de réglage et/ou de commande (11) individuel ou universel adapté au vide.

12. Installation de revêtement sous vide selon l'une quelconque des revendications précédentes, **caractérisée en ce que** l'au moins un entraînement (9) individuel comprend un moteur électrique (9) ou plusieurs moteurs électriques (9) et/ou **en ce que** l'au moins un entraînement (9) individuel comprend un actionneur (9) électrique ou plusieurs actionneurs (9) électriques.

13. Installation de revêtement sous vide selon la revendication 12, **caractérisée en ce que** le moteur électrique est un moteur pas à pas et/ou que les moteurs électriques sont des moteurs pas à pas.

14. Installation de revêtement sous vide selon la revendication 12 ou 13, **caractérisée en ce que** le moteur électrique est un moteur linéaire (9, 6^{*}) et/ou en ce que les moteurs électriques sont des moteurs linéaires (9).

15. Installation de revêtement sous vide selon la revendication 14, **caractérisée en ce qu'**un dispositif de transformation (4^{*}) est prévu pour transformer le mouvement linéaire du moteur linéaire (9, 6^{*}) et/ou des moteurs linéaires (9) en un mouvement de rotation et/ou de retournement.

16. Installation de revêtement sous vide selon la revendication 15, **caractérisée en ce que** le dispositif de transformation (4^{*}) comprend une tige dentée (6^{*}) et une roue dentée (4.2) interagissant avec celle-ci.

17. Installation de revêtement sous vide selon l'une quelconque des revendications 12 à 16, **caractérisée en ce que** le moteur électrique est un moteur miniature (9) piézoélectrique et/ou que les moteurs électriques sont des moteurs miniatures (9) piézoélectriques et/ou que l'actionneur électrique est un actionneur (9) piézoélectrique et/ou que les actionneurs électriques sont des actionneurs (9) piézoélectriques.

18. Dispositif selon la revendication 17, **caractérisé en ce que** le moteur miniature (9) piézoélectrique comporte une pointe de moteur (16) à oscillation elliptique qui est en relation de complémentarité de frottements avec une roue de frottement (6) et/ou une tige de frottement (6^{*}).

19. Installation de revêtement sous vide selon l'une quelconque des revendications précédentes, **caractérisée en ce qu'**un dispositif de fixation (7) est prévu pour la fixation à une calotte (14).

20. Installation de revêtement sous vide selon l'une quelconque des revendications précédentes, **caractérisée en ce qu'**un dispositif de fixation (7) est prévu pour la fixation amovible à une calotte (14).

21. Installation de revêtement sous vide selon la revendication 19 ou 20, **caractérisée en ce que** le dispositif de fixation (7) comprend un dispositif d'ajustement (12.1, 12.2) pour définir la position du dispositif par rapport à la calotte (14).

22. Installation de revêtement sous vide selon l'une quelconque des revendications précédentes, **caractérisée en ce que** le support (3) individuel comporte des zones de collage (2.2, 2.3), notamment au maximum deux zones de collage (2.2, 2.3) auxquelles l'élément (2) optique peut être collé.

23. Installation de revêtement sous vide selon l'une quelconque des revendications précédentes avec une calotte (14) équipée d'une pluralité de dispositifs (1, 17, 18, 19).

24. Procédé destiné à maintenir et tourner et/ou retourner des éléments optiques tels que par exemple des lentilles (2), ou des éléments non optiques tels que par exemple des outils, lors de leur revêtement dans une installation de revêtement sous vide selon l'une quelconque des revendications 1 à 23, chaque élément (2) étant maintenu à l'aide d'un support (3) individuel, **caractérisé en ce que** chaque support (3) individuel est tourné et/ou retourné avec au moins un des entraînements (9) individuels associés au support (3) individuel.

25. Procédé selon la revendication 24, **caractérisé en ce que** le dispositif (1, 17, 18, 19) est tourné et/ou retourné pendant le fonctionnement de l'installation de revêtement sous vide.

26. Procédé selon l'une quelconque des revendications 24 à 25, **caractérisé en ce que** le dispositif (1, 17, 18, 19) est entraîné pendant le revêtement de l'élément (2) à tourner et/ou retourner.

27. Procédé selon l'une quelconque des revendications 24 à 26, **caractérisé en ce que** le dispositif (1, 17, 18, 19) est entraîné en continu pour tourner et/ou retourner l'élément.

28. Procédé selon l'une quelconque des revendications 24 à 27, **caractérisé en ce qu'**une couche fonctionnelle est appliquée lors du revêtement.

29. Procédé selon la revendication 28, **caractérisé en ce que** la couche fonctionnelle comprend une couche à action tribologique.

30. Procédé selon l'une quelconque des revendications 24 à 29, **caractérisé en ce que** l'application de systèmes à plusieurs couches sur le côté avant et arrière de l'élément (2) est réalisée par application d'une couche appliquée d'abord sur la couche avant et arrière, avant d'appliquer la couche suivante.
